# EUROPEAN PATENT APPLICATION

(11) **EP 4 553 820 A1**
(43) Date of publication of application: **14.05.2025**
(21) Application number: 24210999.9
(22) Date of filing: 05.11.2024
(51) Int. Cl.: G09G 3/3233, H10K 59/131, H10K 59/35

(54) **DISPLAY DEVICE**

(30) Priority: 10.11.2023 KR 20230155296; 09.05.2024 KR 20240061269
(71) Applicant: Samsung Display Co., Ltd., Gyeonggi-Do (KR)
(72) Inventor: YANG, Minki, Yongin-si (KR); JIN, Changkyu, Yongin-si (KR); PARK, Kyoungjin, Yongin-si (KR); SHIM, Jung Hoon, Yongin-si (KR)
(74) Representative: Marks & Clerk LLP

(57) **Abstract**

A display device (DP) includes first and second data lines, first and second voltage lines (L1,L2), and a plurality of pixels (PXR, PXG). The plurality of pixels includes a first sub-pixel including a first pixel circuit and a first light emitting element and a second sub-pixel including a second pixel circuit and a second light emitting element. The first voltage line includes a (1-1)-th portion (P1-1) extending in a first direction (DR2) and a (1-2)-th portion (P1-2) electrically connected to the (1-1)-th portion and extending in a second direction (DR1) intersecting the first direction, and the second voltage line includes a (2-1)-th portion (P2-1) extending in the first direction and a (2-2)-th portion (P2-2) electrically connected to the (2-1)-th portion and extending in the second direction.

## Description

### BACKGROUND

### 1. Field

The present invention generally relates to a display device.

### 2. Background

In general, a display device includes a display panel for displaying images and a driving circuit driving the display panel. The display panel includes a plurality of scan lines, a plurality of data lines, and a plurality of pixels. The driving circuit includes a data driving circuit which outputs data driving signals to the data lines, a scan driving circuit which outputs scan signals for driving the scan lines, and a driving controller which controls the data driving circuit and the scan driving circuit.

The display device may display images by outputting a scan signal to a scan line connected to a pixel targeted for display and providing a data voltage corresponding to a display image to a data line connected to the pixel.

Also, each of the plurality of pixels may provide one of various color lights such as a red light, a green light, and a blue light. Each of the plurality of pixels may include a light emitting element and a pixel circuit for driving the light emitting element. The size of each of the plurality of pixels and a way to arrange the plurality of pixels may be variously determined.

The above information disclosed in this Background section is only for enhancement of understanding of the background and therefore the information discussed in this Background section does not necessarily constitute prior art.

### SUMMARY

According to the present invention, there is provided a display device according to claim 1. Preferred embodiments are defined by the dependent claims.

According to some embodiments of the present disclosure, a display device includes a first data line and a second data line each extending in a first direction, a first voltage line and a second voltage line providing different initialization voltages, and a plurality of pixels. The plurality of pixels may include a first sub-pixel electrically connected to the first data line and the first voltage line and including a first pixel circuit and a first light emitting element, and a second sub-pixel adjacent to the first sub-pixel, electrically connected to the second data line and the second voltage line, and including a second pixel circuit and a second light emitting element. The first voltage line may include a (1-1)-th portion extending in the first direction and a (1-2)-th portion electrically connected to the (1-1)-th portion and extending in a second direction intersecting the first direction, and the second voltage line may include a (2-1)-th portion extending in the first direction and a (2-2)-th portion electrically connected to the (2-1)-th portion and extending in the second direction.

According to some embodiments, the (1-1)-th portion and the (2-1)-th portion may be in a same layer, and the (1-1)-th portion and the (1-2)-th portion may be in different layers.

According to some embodiments, the first and second data lines, the (1-1)-th portion, and the (2-1)-th portion are in a same layer.

According to some embodiments, the first pixel circuit may include a (1-1)-th initialization transistor connected between the first voltage line and the first light emitting element, and the second pixel circuit may include a (1-2)-th initialization transistor connected between the second voltage line and the second light emitting element.

According to some embodiments, the first pixel circuit may include a first driving transistor and a (2-1)-th initialization transistor connected between a gate electrode of the first driving transistor and the first voltage line, and the second pixel circuit may include a second driving transistor and a (2-2)-th initialization transistor connected between a gate electrode of the second driving transistor and the second voltage line.

According to some embodiments, the display device may further include a third data line, and a third voltage line providing a voltage different from those of the first voltage line and the second voltage line. The plurality of pixels may further include a third pixel adjacent to the second sub-pixel and including a third pixel circuit and a third light emitting element, and the third pixel may be electrically connected to the third voltage line.

According to some embodiments, the third voltage line may include a (3-1)-th portion extending in the first direction and a (3-2)-th portion electrically connected to the (3-1)-th portion and extending in the second direction.

According to some embodiments, different color data may be provided to the first to third data lines.

According to some embodiments, each of the first pixel circuit and the second pixel circuit may be provided in plurality, the plurality of first pixel circuits may be arranged along the first direction, the plurality of second pixel circuits may be arranged along the first direction, and the plurality of first pixel circuits may be respectively spaced from the plurality of second pixel circuits in the second direction.

According to some embodiments, the first light emitting element may be provided in plurality, and the plurality of first light emitting elements may be electrically connected to the plurality of first pixel circuits, respectively. In a plan view, some of the plurality of first light emitting elements may overlap the corresponding first pixel circuits. In the plan view, the others of the plurality of first light emitting elements may not overlap the corresponding first pixel circuits.

According to some embodiments, in a plan view, the second data line may overlap the first light emitting element and does not overlap the second light emitting element.

According to some embodiments, the first data line and the second data line may be spaced from each other in the second direction.

According to some embodiments, in a plan view, each of the first voltage line, the second voltage line, and the third voltage line may have a mesh structure.

According to some embodiments of the present disclosure, a display device may include a data line extending in a first direction, a voltage line transferring an initialization voltage, and a pixel electrically connected to the data line and the voltage line. The pixel may include a pixel circuit and a light emitting element, the voltage line may include a first portion extending in the first direction and a second portion electrically connected to the first portion and extending in a second direction intersecting the first direction, the first portion and the second portion may be in different layers, and the data line and the first portion may be in a same layer.

According to some embodiments, the pixel circuit may include a first initialization transistor connected between the voltage line and the light emitting element.

According to some embodiments, the pixel circuit may include a driving transistor, and a second initialization transistor connected between a gate electrode of the driving transistor and the voltage line.

According to some embodiments, the pixel circuit may be provided in plurality, and the plurality of pixel circuits may be arranged along the first direction.

According to some embodiments, the light emitting element may be provided in plurality, and the plurality of light emitting elements may be electrically connected to the plurality of pixel circuits, respectively.

According to some embodiments, in a plan view, some of the plurality of light emitting elements may overlap the corresponding pixel circuits.

According to some embodiments, in the plan view, the others of the plurality of light emitting elements may not overlap the corresponding pixel circuits.

### BRIEF DESCRIPTION OF THE DRAWINGS

The above and other aspects and features of the present invention will become apparent by describing in detail embodiments thereof with reference to the accompanying drawings.
FIG. 1 is a block diagram of a display device according to some embodiments of the present disclosure.
FIG. 2 illustrates a partial configuration of a display panel according to some embodiments of the present disclosure.
FIG. 3 illustrates a partial configuration of a display panel according to some embodiments of the present disclosure.
FIGS. 4A to 4C are circuit diagrams of first to third sub-pixels according to some embodiments of the present disclosure.
FIGS. 5A to 5C are circuit diagrams of first to third sub-pixels according to some embodiments of the present disclosure.
FIG. 6 is a cross-sectional view of a display panel taken along line I-I' of FIG. 1, according to some embodiments of the present disclosure.
FIG. 7 is a plan view illustrating one layer of a display panel according to some embodiments of the present disclosure.
FIG. 8 is a plan view illustrating one layer of a display panel according to some embodiments of the present disclosure.
FIG. 9 is a plan view illustrating one layer of a display panel according to some embodiments of the present disclosure.
FIG. 10 illustrates a partial configuration of a display panel according to some embodiments of the present disclosure.

### DETAILED DESCRIPTION

In the specification, the expression that a first component (or an area, a layer, a part, or a portion) is "on", "connected to", or "coupled to" a second component means that the first component is directly on/connected to/coupled to the second component or means that a third component is interposed therebetween.

The same reference numerals refer to the same components. In addition, in drawings, thicknesses, proportions, and dimensions of components may be exaggerated to describe the technical features effectively. The expression "and/or" includes one or more combinations which associated components are capable of defining.

Although the terms "first", "second", etc. may be used to describe various components, the components should not be construed as being limited by the terms. The terms are only used to distinguish one component from another component. For example, without departing from the scope of the invention that is defined by the claims, a first component may be referred to as a "second component", and similarly, the second component may be referred to as the "first component". The singular forms are intended to include the plural forms unless the context clearly indicates otherwise.

Also, the terms "under", "below", "on", "above", etc. are used to describe the correlation of components illustrated in drawings. The terms that are relative in concept are described based on a direction shown in drawings.

It will be further understood that the terms "comprises", "includes", "have", etc. specify the presence of stated features, numbers, steps, operations, elements, components, or a combination thereof but do not preclude the presence or addition of one or more other features, numbers, steps, operations, elements, components, or a combination thereof.

Unless otherwise defined, all terms (including technical terms and scientific terms) used in the specification have the same meaning as commonly understood by one skilled in the art to which the present disclosure belongs. Furthermore, terms such as terms defined in the dictionaries commonly used should be interpreted as having a meaning consistent with the meaning in the context of the related technology, and should not be interpreted in ideal or overly formal meanings unless explicitly defined herein.

Below, embodiments of the present invention will be described in more detail with reference to drawings.

Some embodiments described herein relate to a display device with relatively improved display quality or capable of relatively improving the quality of display.

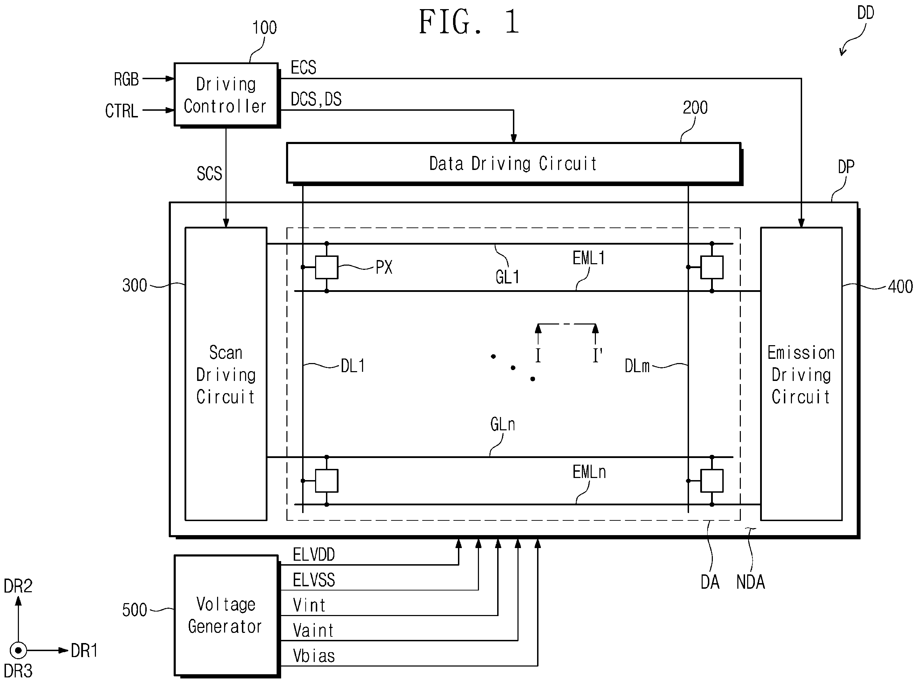

FIG. 1 is a block diagram of a display device according to some embodiments of the present disclosure.

Referring to FIG. 1, a display device DD may include a driving controller 100, a data driving circuit 200, a voltage generator 500, and a display panel DP.

The driving controller 100 may receive an input image signal RGB and a control signal CTRL. The driving controller 100 may generate an output image signal DS obtained by converting the input image signal RGB so as to have an image type appropriate for the display panel DP. The driving controller 100 may output a scan control signal SCS and a data control signal DCS.

The display panel DP according to some embodiments of the present disclosure may be a light emitting display panel, but embodiments according to the present invention are not limited thereto. For example, the display panel DP may be an organic light emitting display panel, a quantum dot display panel, a micro-LED display panel, or a nano-LED display panel. A light emitting layer of the organic light emitting display panel may include an organic light emitting material. A light emitting layer of the quantum dot light emitting display panel may include a quantum dot, a quantum rod, etc. A light emitting layer of the micro-LED display panel may include a micro-LED. A light emitting layer of the nano-LED display panel may include a nano-LED.

The display panel DP may include scan lines GL1 to GLn, data lines DL1 to DLm, and a plurality of pixels PX.

A display area DA and a non-display area NDA may be defined in the display panel DP. The display panel DP may display images through the display area DA so as to face a third direction DR3 intersecting a first direction DR1 and a second direction DR2. The non-display area NDA may be located adjacent to (e.g., in a periphery or outside a footprint of) the display area DA. The non-display area NDA may surround the display area DA.

The display panel DP may further include a scan driving circuit 300 and an emission driving circuit 400. The pixels PX may be located in the display area DA, and the scan driving circuit 300 and the emission driving circuit 400 may be located in the non-display area NDA. The number of pixels PX may vary according to the design and size of the display area DA.

The scan lines GL1 to GLn may extend from the scan driving circuit 300 in the first direction DR1 and/or may be arranged to be spaced from each other in the second direction DR2. Emission control lines EML1 to EMLn may extend from the emission driving circuit 400 in a direction facing away from the first direction DR1 and/or may be arranged to be spaced from each other in the second direction DR2. The data lines DL1 to DLm may extend from the data driving circuit 200 in the second direction DR2 and/or may be arranged to be spaced from each other in the first direction DR1.

Each of the plurality of pixels PX may be connected to a corresponding scan line among the scan lines GL1 to GLn, may be connected to a corresponding data line among the data lines DL1 to DLm, and may be connected to a corresponding emission control line among the emission control lines EML1 to EMLn. An example in which each of the plurality of pixels PX is connected to one scan line is illustrated in FIG. 1, but embodiments according to the present invention are not limited thereto. For example, each of the plurality of pixels PX may be electrically connected to two or more scan lines.

Each of the plurality of pixels PX may include a light emitting element and a pixel circuit controlling the emission of the light emitting element. The light emitting element and the pixel circuit will be described later.

The data driving circuit 200 may receive the data control signal DCS and the output image signal DS from the driving controller 100. The data driving circuit 200 converts the output image signal DS into first to third color data signals and outputs the first to third color data signals to the data lines DL1 to DLm, respectively. Each of the first to third color data signals may have a voltage level corresponding to a gray level of the output image signal DS.

The data driving circuit 200 may be implemented with an integrated circuit (IC) and may be directly mounted in a given area of the display panel DP. Alternatively, the data driving circuit 200 may be mounted on a separate printed circuit board in a chip on film (COF) scheme so as to be electrically connected to the display panel DP. According to some embodiments, the data driving circuit 200 may be formed on the display panel DP by using the same process as the pixel circuit of each of the plurality of pixels PX.

The scan driving circuit 300 may receive the scan control signal SCS from the driving controller 100. The scan driving circuit 300 may output scan signals to the scan lines GL1 to GLn in response to the scan control signal SCS. According to some embodiments, the scan driving circuit 300 may be formed in the same process as the pixel circuit of each of the plurality of pixels PX.

The emission driving circuit 400 may receive an emission driving signal ECS from the driving controller 100. The emission driving circuit 400 may output emission control signals to the emission control lines EML1 to EMLn in response to the emission driving signal ECS. According to some embodiments, the emission driving circuit 400 may be formed in the same process as the pixel circuit of each of the plurality of pixels PX. The emission driving circuit 400 is illustrated in FIG. 1, but embodiments according to the present invention are not limited thereto. According to some embodiments, the emission driving circuit 400 may be included in the scan driving circuit 300.

The driving controller 100, the data driving circuit 200, the scan driving circuit 300, and the emission driving circuit 400 may constitute a driving circuit for providing the first to third color data signals corresponding to the input image signal RGB to the pixels PX.

The voltage generator 500 may generate voltages necessary for the operation of the display panel DP. The voltage generator 500 may generate the voltages to the display panel DP. According to some embodiments of the present disclosure, the voltages may include preferably all of a first driving voltage ELVDD, a second driving voltage ELVSS, a first initialization voltage Vint, and a second initialization voltage Vaint.

The voltage level of the first initialization voltage Vint may be higher than the voltage level of the second initialization voltage Vaint. However, this is only an example, and the voltage levels of the first initialization voltage Vint and the second initialization voltage Vaint are not limited thereto. For example, the first initialization voltage Vint and the second initialization voltage Vaint may have the same voltage level.

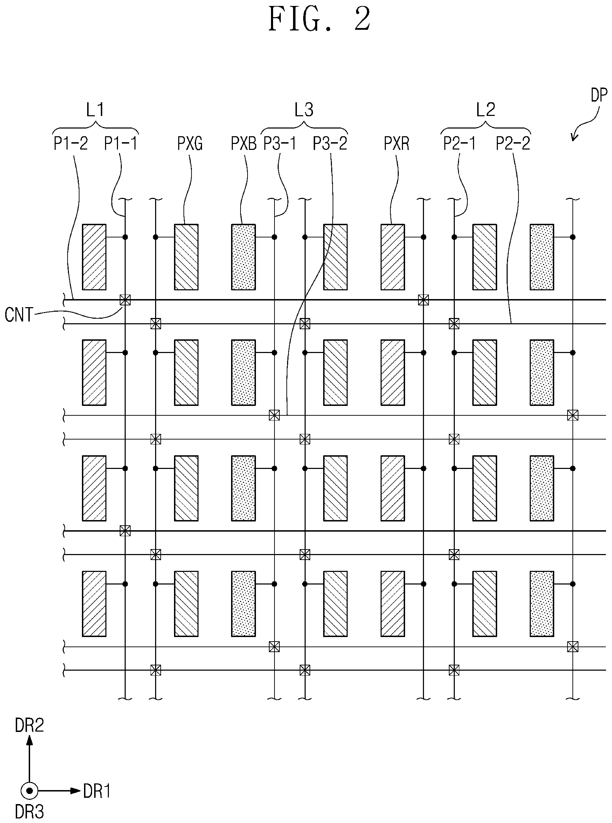

FIG. 2 illustrates a partial configuration of a display panel according to some embodiments of the present disclosure.

Referring to FIG. 2, the display panel DP may include preferably all of a plurality of first sub-pixels PXR, a plurality of second sub-pixels PXG, a plurality of third sub-pixels PXB, a first voltage line L1, a second voltage line L2, and/or a third voltage line L3.

The plurality of pixels PX (refer to FIG.1) may include the first sub-pixel PXR, the second sub-pixel PXG, and/or the third sub-pixel PXB.

The first sub-pixel PXR may be electrically connected to the first voltage line L1. The first sub-pixel PXR may emit a first light.

The second sub-pixel PXG may be adjacent to the first sub-pixel PXR. The second sub-pixel PXG may be electrically connected to the second voltage line L2. The second sub-pixel PXG may emit a second light.

The third sub-pixel PXB may be adjacent to the second sub-pixel PXG. The third sub-pixel PXB may be electrically connected to the third voltage line L3. The third sub-pixel PXB may emit a third light.

According to some embodiments, the first to third lights may be different color lights.

According to some embodiments, the first to third lights may be a red light, a green light, and a blue light, respectively. However, embodiments according to the present invention are not limited thereto. According to some embodiments, the first to third lights may be lights with various colors such as a white, a cyan, a magenta, and a yellow, as well as a blue, a green, and a red.

The first sub-pixel PXR, the second sub-pixel PXG, and the third sub-pixel PXB may be arranged along the first direction DR1.

Each of the first sub-pixel PXR, the second sub-pixel PXG, and the third sub-pixel PXB may be provided in plurality.

The plurality of first sub-pixels PXR, the plurality of second sub-pixels PXG, and the plurality of third sub-pixels PXB may be arranged in the second direction DR2.

Meanwhile, an example of the arrangement shape of the first to third sub-pixels PXR, PXG, and PXB is illustrated in FIG. 2, but embodiments according to the present invention are not limited thereto. For example, the first to third sub-pixels PXR, PXG, and PXB may be arranged in various shapes. According to some embodiments, the first to third sub-pixels PXR, PXG, and PXB may be arranged in the shape of the PENTILE^{™}. Alternatively, the first to third sub-pixels PXR, PXG, and PXB may be arranged in the shape of a stripe or in the shape of the Diamond Pixel^{™}.

The first initialization voltage Vint (refer to FIG.1) and/or the second initialization voltage Vaint (refer to FIG.1) corresponding to the plurality of first sub-pixels PXR may be provided to the first voltage line L1. This will be described in more detail below.

The first voltage line L1 may include a (1-1)-th portion P1-1 and a (1-2)-th portion P1-2. The (1-1)-th portion P1-1 may extend in the second direction DR2. The (1-2)-th portion P1-2 may be electrically connected to the (1-1)-th portion P1-1. The (1-2)-th portion P1-2 may extend in the first direction DR1. The first voltage line L1 may have a mesh shape.

The (1-1)-th portion P1-1 and the (1-2)-th portion P1-2 may be located in different layers. The (1-1)-th portion P1-1 and the (1-2)-th portion P1-2 may be electrically connected through a contact hole CNT.

The (1-1)-th portion P1-1 may be provided in plurality. The plurality of (1-1)-th portions P1-1 may be located adjacent to the first sub-pixels PXR so as to be electrically connected thereto.

The first initialization voltage Vint (refer to FIG.1) or the second initialization voltage Vaint (refer to FIG.1) corresponding to the second sub-pixel PXG may be provided to the second voltage line L2. This will be described in more detail below.

The second voltage line L2 may include a (2-1)-th portion P2-1 and a (2-2)-th portion P2-2. The (2-1)-th portion P2-1 may extend in the second direction DR2. The (2-2)-th portion P2-2 may be electrically connected to the (2-1)-th portion P2-1. The (2-2)-th portion P2-2 may extend in the first direction DR1. The second voltage line L2 may have a mesh shape.

The (2-1)-th portion P2-1 and the (2-2)-th portion P2-2 may be located in different layers. The (2-1)-th portion P2-1 and the (2-2)-th portion P2-2 may be electrically connected through a contact hole CNT.

The (2-1)-th portion P2-1 may be provided in plurality. The plurality of (2-1)-th portions P2-1 may be located adjacent to the second sub-pixels PXG so as to be electrically connected thereto.

The first initialization voltage Vint (refer to FIG.1) or the second initialization voltage Vaint (refer to FIG.1) corresponding to the third sub-pixel PXB may be provided to the third voltage line L3. This will be described in more detail below.

The third voltage line L3 may include a (3-1)-th portion P3-1 and a (3-2)-th portion P3-2. The (3-1)-th portion P3-1 may extend in the second direction DR2. The (3-2)-th portion P3-2 may be electrically connected to the (3-1)-th portion P3-1. The (3-2)-th portion P3-2 may extend in the first direction DR1. The third voltage line L3 may have a mesh shape.

The (3-1)-th portion P3-1 and the (3-2)-th portion P3-2 may be located in different layers. The (3-1)-th portion P3-1 and the (3-2)-th portion P3-2 may be electrically connected through a contact hole CNT.

The (3-1)-th portion P3-1 may be provided in plurality. The plurality of (3-1)-th portions P3-1 may be located adjacent to the third sub-pixels PXB so as to be electrically connected thereto.

According to embodiments, the first to third voltage lines L1, L2, and L3 may have a mesh structure. In this case, compared to a conventional voltage line extending in the second direction DR2, the first to third voltage lines L1, L2, and L3 may further include the second portions P1-2, P2-2, and P3-2 extending in the first direction DR1. The area of wiring for providing the initialization voltages Vint and Vaint (refer to FIG.1) may increase, and the resistance thereof may decrease. As the first to third voltage lines L1, L2, and L3 transfer the initialization voltages Vint and Vaint (refer to FIG.1), the load of the first to third voltage lines L1, L2, and L3 may decrease. According to the above description, the display device DD (refer to FIG. 1) whose reliability may be relatively improved may be provided.

Also, unlike some embodiments, when the initialization voltage Vint or Vaint (refer to FIG.1) is provided through a common wire (or line), the common wire may function as a charge transfer path when the first to third sub-pixels PXR, PXG, and PXB are driven. While one sub-pixel is driven, charges may flow to another sub-pixel adjacent to the one sub-pixel through the common wire, that is, a lateral leakage current may be caused. However, according to embodiments, the first to third voltage lines L1, L2, and L3 may be respectively connected to the first to third sub-pixels PXR, PXG, and PXB. Accordingly, the phenomenon that charges flow to another sub-pixel adjacent to one sub-pixel while the one sub-pixel is driven may be prevented, reduced, or removed. A color deviation capable of being caused by the lateral leakage current may be prevented, reduced, or removed. According to the above description, the display device DD (refer to FIG. 1) whose display quality may be relatively improved may be provided.

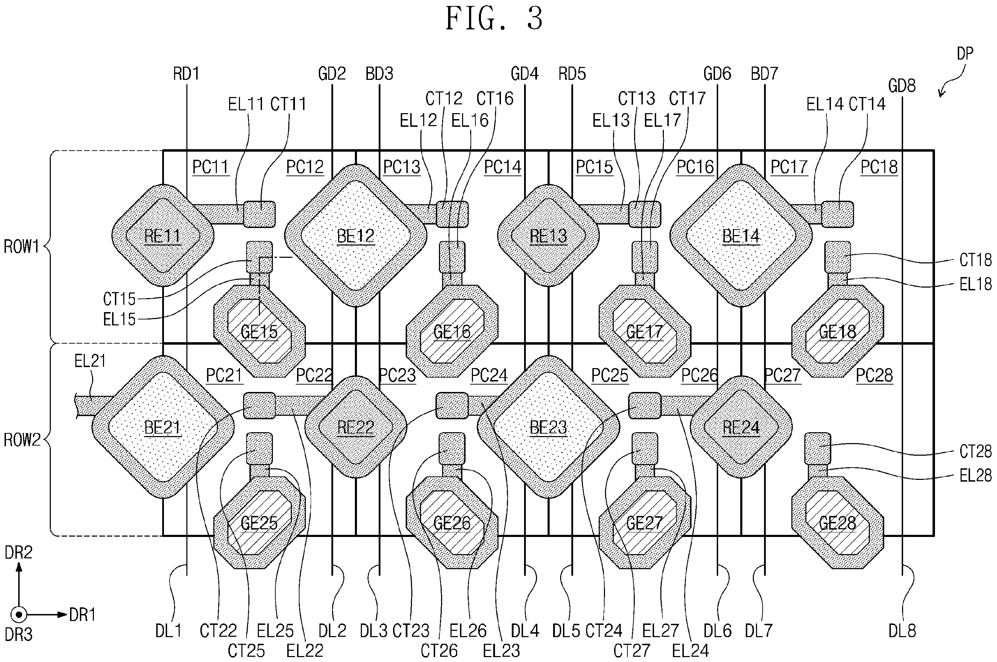

FIG. 3 illustrates a partial configuration of a display panel according to some embodiments of the present disclosure.

Referring to FIG. 3, the display panel DP may include a plurality (eg 8) of data lines DL1 to DL8, a plurality of first pixel circuits eg PC11, PC15, PC21, and PC25, a plurality of second pixel circuits eg PC12, PC14, PC16, PC18, PC22, PC24, PC26, and PC28, a plurality of third pixel circuits eg PC13, PC17, PC23, and PC27, a plurality of first light emitting elements eg RE11, RE13, RE22, and RE24, a plurality of second light emitting elements eg GE15 to GE18 and GE25 to GE28, and a plurality of third light emitting elements eg BE12, BE14, BE21, and BE23.

The plurality of first pixel circuits PC11, PC15, PC21, and PC25 and the plurality of first light emitting elements RE11, RE13, RE22, and RE24 corresponding thereto may be included in the first sub-pixels PXR (refer to FIG.2).

The plurality of second pixel circuits PC12, PC14, PC16, PC18, PC22, PC24, PC26, and PC28 and the plurality of second light emitting elements GE15 to GE18 and GE25 to GE28 corresponding thereto may be included in the second sub-pixels PXG (refer to FIG.2).

The plurality of third pixel circuits PC13, PC17, PC23, and PC27 and the plurality of third light emitting elements BE12, BE14, BE21, and BE23 corresponding thereto may be included in the third sub-pixels PXB (refer to FIG.2).

Some first pixel circuits eg PC11 and PC15 among the plurality of first pixel circuits PC11, PC15, PC21, and PC25, some second pixel circuits eg PC12, PC14, PC16, and PC18 among the plurality of second pixel circuits PC12, PC14, PC16, PC18, PC22, PC24, PC26, and PC28, and some third pixel circuits eg PC13 and PC17 among the plurality of third pixel circuits PC13, PC17, PC23, and PC27 may be located at a first row ROW1 and may be sequentially arranged in the first direction DR1.

Some first pixel circuits eg PC21 and PC25 among the plurality of first pixel circuits PC11, PC15, PC21, and PC25, some second pixel circuits eg PC22, PC24, PC26, and PC28 among the plurality of second pixel circuits PC12, PC14, PC16, PC18, PC22, PC24, PC26, and PC28, and some third pixel circuits eg PC23 and PC27 among the plurality of third pixel circuits PC13, PC17, PC23, and PC27 may be located at a second row ROW2 and may be sequentially arranged in the first direction DR1. The second row ROW2 may be spaced from the first row ROW1 in the second direction DR2.

Each of the plurality of data lines DL1 to DL8 may extend in the second direction DR2. The plurality of data lines DL1 to DL8 may be arranged to be spaced from each other in the first direction DR1.

The plurality of data lines DL1 to DL8 may include the first data line DL1, the second data line DL2, the third data line DL3, the fourth data line DL4, the fifth data line DL5, the sixth data line DL6, the seventh data line DL7, and the eighth data line DL8.

Some of the plurality of data lines DL1 to DL8 may be located adjacent to each other in pairs. That is, the second data line DL2 and the third data line DL3 may be located adjacent to each other, the fourth data line DL4 and the fifth data line DL5 may be located adjacent to each other, and the sixth data line DL6 and the seventh data line DL7 may be located adjacent to each other.

Each of the pixel circuits PC11 to PC18 located at the first row ROW1 may be connected to a corresponding data line among the plurality of data lines DL1 to DL8.

Each of the pixel circuits PC21 to PC28 located at the second row ROW2 may be connected to a corresponding data line among the plurality of data lines DL1 to DL8.

In a plan view, the first data line DL1 may overlap the first light emitting element RE11 and the third light emitting element BE21.

In a plan view, the second data line DL2 may not overlap the second light emitting elements GE15 and GE25.

In a plan view, the second data line DL2 and the third data line DL3 may overlap the third light emitting element BE12 and the first light emitting element RE22.

In a plan view, the fourth data line DL4 may not overlap the second light emitting elements GE16 and GE26.

In a plan view, the fourth data line DL4 and the fifth data line DL5 may overlap the first light emitting element RE13 and the third light emitting element BE23.

In a plan view, the sixth data line DL6 may not overlap the second light emitting elements GE17 and GE27.

In a plan view, the sixth data line DL6 and the seventh data line DL7 may overlap the third light emitting element BE14 and the first light emitting element RE24.

In a plan view, the eighth data line DL8 may not overlap the second light emitting elements GE18 and GE28.

The first light emitting element RE11, the second light emitting element GE15, the third light emitting element BE12, the second light emitting element GE16, the first light emitting element RE13, the second light emitting element GE17, the third light emitting element BE14, and the second light emitting element GE18 may be sequentially arranged in the first direction DR1 at the first row ROW1.

The third light emitting element BE21, the second light emitting element GE25, the first light emitting element RE22, the second light emitting element GE26, the third light emitting element BE23, the second light emitting element GE27, the first light emitting element RE24, and the second light emitting element GE28 may be sequentially arranged in the first direction DR1 at the second row ROW2.

In a plan view, the first light emitting elements RE11 and RE13 located at the first row ROW1 may respectively overlap the first pixel circuits PC11 and PC15 corresponding thereto, and the first light emitting elements RE22 and RE24 located at the second row ROW2 may not respectively overlap the first pixel circuits PC21 and PC25 corresponding thereto.

In a plan view, the second light emitting elements GE15 to GE18 and GE25 to GE28 may respectively overlap the second pixel circuits PC12, PC14, PC16, PC18, PC22, PC24, PC26, and PC28 corresponding thereto.

In a plan view, the third light emitting elements BE12 and BE14 located at the first row ROW1 may respectively overlap the third pixel circuits PC13 and PC17 corresponding thereto, and the third light emitting elements BE21 and BE23 located at the second row ROW2 may not respectively overlap the third pixel circuits PC23 and PC27 corresponding thereto.

In FIG. 3, the size and shape of each of the plurality of first light emitting elements RE11, RE13, RE22, and RE24, the plurality of second light emitting elements GE15 to GE18 and GE25 to GE28, and the plurality of third light emitting elements BE12, BE14, BE21, and BE23 and the placement order thereof are provided as an example for better understanding, and embodiments according to the present invention are not limited thereto.

An example in which the plurality of first light emitting elements RE11, RE13, RE22, and RE24, the plurality of second light emitting elements GE15 to GE18 and GE25 to GE28, and the plurality of third light emitting elements BE12, BE14, BE21, and BE23 are arranged in the shape of the PENTILE^{™} is illustrated in FIG. 3. However, light emitting elements may be arranged in the shape of a stripe or in the shape of the Diamond Pixel^{™}.

Each of the plurality of first light emitting elements RE11, RE13, RE22, and RE24 may emit a first light. For example, the first light may be a red light.

Each of the plurality of second light emitting elements GE15 to GE18 and GE25 to GE28 may emit a second light. For example, the second light may be a green light.

Each of the plurality of third light emitting elements BE12, BE14, BE21, and BE23 may emit a third light. For example, the third light may be a blue light.

Each of the first light emitting elements RE11 and RE13, the second light emitting elements GE15 to GE18, and the third light emitting elements BE12 and BE14 of the first row ROW1 may be electrically connected to the corresponding pixel circuit among the pixel circuits PC11 to PC18 of the first row ROW1 through a corresponding extension line among a plurality of extension lines (or a plurality of extension electrodes) EL11 to EL18.

The plurality of extension lines EL11 to EL18 may include the first extension line EL11, the second extension line EL12, the third extension line EL13, the fourth extension line EL14, the fifth extension line EL15, the sixth extension line EL16, the seventh extension line EL17, and the eighth extension line EL18.

The first extension line EL11 may extend in the first direction DR1 and may be electrically connected between the first light emitting element RE11 and the first pixel circuit PC11 through a first contact hole CT11.

The second extension line EL12 may extend in the first direction DR1 and may be electrically connected between the third light emitting element BE12 and the third pixel circuit PC13 through a second contact hole CT12.

The third extension line EL13 may extend in the first direction DR1 and may be electrically connected between the first light emitting element RE13 and the first pixel circuit PC15 through a third contact hole CT13.

The fourth extension line EL14 may extend in the first direction DR1 and may be electrically connected between the third light emitting element BE14 and the third pixel circuit PC17 through a fourth contact hole CT14.

The fifth extension line EL15 may extend in the second direction DR2 and may be electrically connected between the second light emitting element GE15 and the second pixel circuit PC12 through a fifth contact hole CT15.

The sixth extension line EL16 may extend in the second direction DR2 and may be electrically connected between the second light emitting element GE16 and the second pixel circuit PC14 through a sixth contact hole CT16.

The seventh extension line EL17 may extend in the second direction DR2 and may be electrically connected between the second light emitting element GE17 and the second pixel circuit PC16 through a seventh contact hole CT17.

The eighth extension line EL18 may extend in the second direction DR2 and may be electrically connected between the second light emitting element GE18 and the second pixel circuit PC18 through an eighth contact hole CT18.

Each of the first light emitting elements RE22 and RE24, the second light emitting elements GE25 to GE28, and the third light emitting elements BE21 and BE23 of the second row ROW2 may be electrically connected to the corresponding pixel circuit among the pixel circuits PC21 to PC28 of the second row ROW2 through a corresponding extension line among a plurality of extension lines EL21 to EL28.

The plurality of extension lines EL21 to EL28 may include the ninth extension line EL21, the tenth extension line EL22, the 11th extension line EL23, the 12th extension line EL24, the 13th extension line EL25, the 14th extension line EL26, the 15th extension line EL27, and the 16th extension line EL28.

The ninth extension line EL21 may extend in the first direction DR1 and may be electrically connected between the third light emitting element BE21 and a third pixel circuit through a third contact hole.

The tenth extension line EL22 may extend in the first direction DR1 and may be electrically connected between the first light emitting element RE22 and the first pixel circuit PC21 through a second contact hole CT22.

The 11th extension line EL23 may extend in the first direction DR1 and may be electrically connected between the third light emitting element BE23 and the third pixel circuit PC23 through a third contact hole CT23.

The 12th extension line EL24 may extend in the first direction DR1 and may be electrically connected between the first light emitting element RE24 and the first pixel circuit PC25 through a fourth contact hole CT24.

The 13th extension line EL25 may extend in the second direction DR2 and may be electrically connected between the second light emitting element GE25 and the second pixel circuit PC22 through a second contact hole CT25.

The 14th extension line EL26 may extend in the second direction DR2 and may be electrically connected between the second light emitting element GE26 and the second pixel circuit PC24 through a second contact hole CT26.

The 15th extension line EL27 may extend in the second direction DR2 and may be electrically connected between the second light emitting element GE27 and the second pixel circuit PC26 through a second contact hole CT27.

The 16th extension line EL28 may extend in the second direction DR2 and may be electrically connected between the second light emitting element GE28 and the second pixel circuit PC28 through a second contact hole CT28.

The data driving circuit 200 may output first color data signals RD1 and RD5 to the data lines DL1 and DL5, respectively, may output second color data signals GD2, GD4, GD6, and GD8 to the data lines DL2, DL4, DL6, and DL8, respectively, and may output third color data signals BD3 and BD7 to the data lines DL3 and DL7, respectively.

According to some embodiments, each of the first color data signals RD1 and RD5 may be a red data signal, each of the second color data signals GD2, GD4, GD6, and GD8 may be a green data signal, and each of the third color data signals BD3 and BD7 may be a blue data signal.

As the data driving circuit 200 (refer to FIG. 2) only outputs a data signal corresponding to a specific color to each of the data lines DL1 to DL8, power consumption may be relatively reduced.

For example, a current corresponding to the first color data signal RD1 provided to the first data line DL1 may be transferred to the first light emitting elements RE11 and RE22 through the first pixel circuits PC11 and PC21.

A current corresponding to the second color data signal GD2 provided to the second data line DL2 may be transferred to the second light emitting elements GE15 and GE25 through the second pixel circuits PC12 and PC22.

A current corresponding to the third color data signal BD3 provided to the third data line DL3 may be transferred to the third light emitting elements BE12 and BE23 through the third pixel circuits PC13 and PC23.

A current corresponding to the second color data signal GD4 provided to the fourth data line DL4 may be transferred to the second light emitting elements GE16 and GE26 through the second pixel circuits PC14 and PC24.

A current corresponding to the first color data signal RD5 provided to the fifth data line DL5 may be transferred to the first light emitting elements RE13 and RE24 through the first pixel circuits PC15 and PC25.

A current corresponding to the second color data signal GD6 provided to the sixth data line DL6 may be transferred to the second light emitting elements GE17 and GE27 through the second pixel circuits PC16 and PC26.

A current corresponding to the third color data signal BD7 provided to the seventh data line DL7 may be transferred to the third light emitting element BE14 through the third pixel circuit PC17.

A current corresponding to the second color data signal GD8 provided to the eighth data line DL8 may be transferred to the second light emitting elements GE18 and GE28 through the second pixel circuits PC18 and PC28.

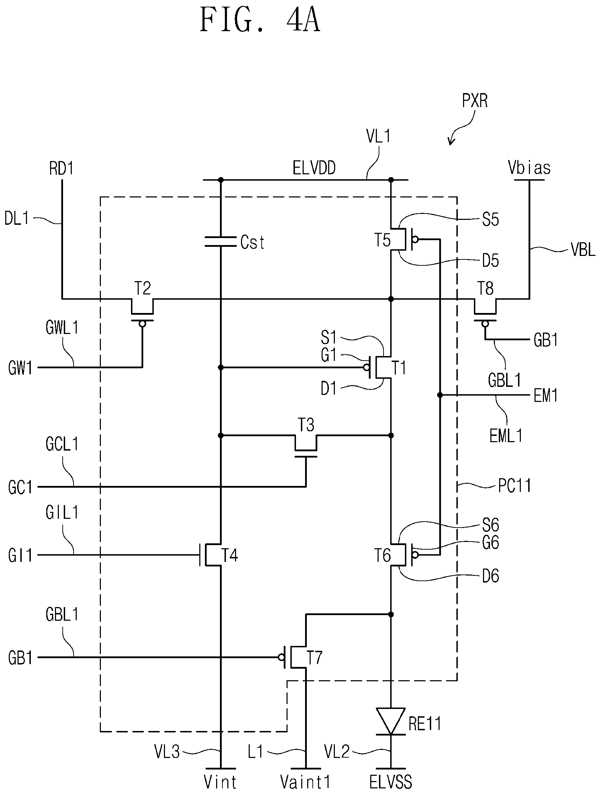

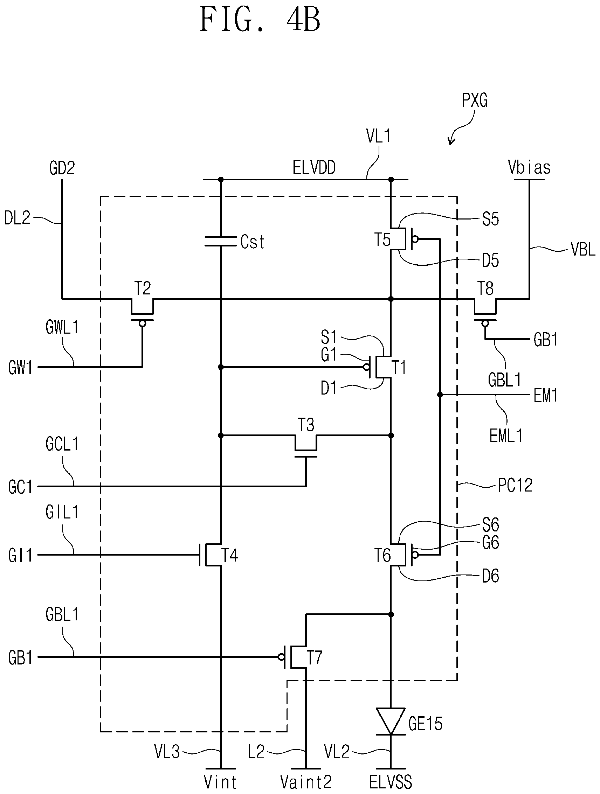

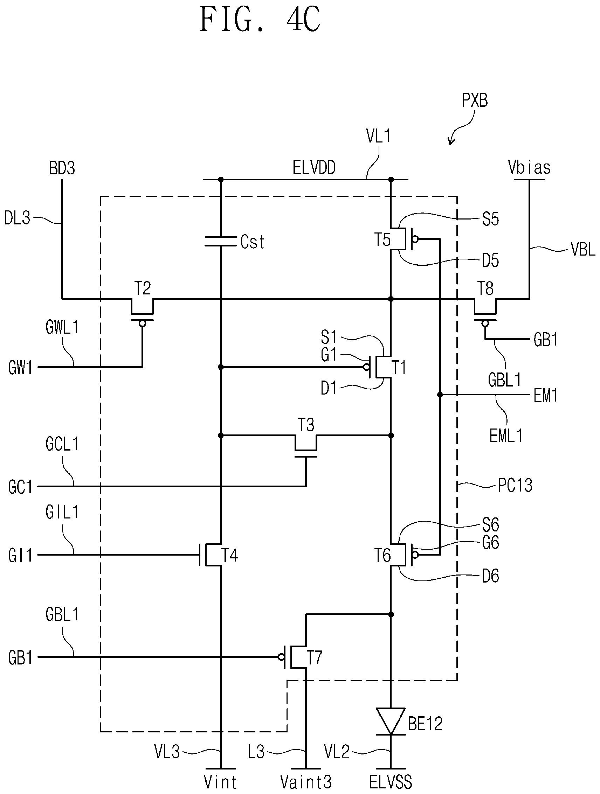

FIGS. 4A to 4C are circuit diagrams of first to third sub-pixels according to some embodiments of the present disclosure.

Referring to FIGS. 3 to 4C, the first sub-pixel PXR may include the first pixel circuit PC11 and the first light emitting element RE11.

The second sub-pixel PXG may include the second pixel circuit PC12 and the second light emitting element GE15.

The third sub-pixel PXB may include the third pixel circuit PC13 and the third light emitting element BE12.

Each of the first light emitting element RE11, the second light emitting element GE15, and the third light emitting element BE12 may be a light emitting diode.

Each of the first pixel circuit PC11, the second pixel circuit PC12, and the third pixel circuit PC13 may include at least one transistor and at least one capacitor. Each of the first pixel circuit PC11, the second pixel circuit PC12, and the third pixel circuit PC13 may include preferably all of first to eighth transistors T1, T2, T3, T4, T5, T6, T7, and T8 and a capacitor Cst. For example, each of the first pixel circuit PC11, the second pixel circuit PC12, and the third pixel circuit PC13 may be defined as having an 8T1C structure.

According to some embodiments, the third and fourth transistors T3 and T4 among the first to eighth transistors T1 to T8 are N-type transistors each using an oxide semiconductor as a semiconductor layer, and each of the first, second, fifth, sixth, seventh, and eighth transistors T1, T2, T5, T6, T7, and T8 are P-type transistors each having a low-temperature polycrystalline silicon (LTPS) semiconductor layer. However, embodiments according to the present invention are not limited thereto. According to some embodiments, all the first to eighth transistors T1 to T8 may be P-type transistors or N-type transistors. According to some embodiments, at least one of the first to eighth transistors T1 to T8 may be an N-type transistor, and the remaining transistors thereof may be P-type transistors.

According to some embodiments, each of the first pixel circuit PC11, the second pixel circuit PC12, and the third pixel circuit PC13 may be electrically connected to four scan lines and one emission control line EML1. According to some embodiments, the first pixel circuit PC11 may be electrically connected to one data line DL1, the second pixel circuit PC12 may be electrically connected to one data line DL2, and the third pixel circuit PC13 may be electrically connected to one data line DL3. Each of the scan lines GL1 to GLn illustrated in FIG. 1 may include a plurality of scan lines. According to some embodiments, the scan line GL1 illustrated in FIG. 1 may include four scan lines GIL1, GCL1, GWL1, and GBL1.

The scan lines GIL1, GCL1, GWL1, and GBL1 may respectively transfer scan signals GI1, GC1, GW1, and GB1, and the emission control line EML1 may transfer an emission control signal EM1. The first data line DL1 may transfer the first color data signal RD1. The second data line DL2 may transfer the second color data signal GD2. The third data line DL3 may transfer the third color data signal BD3. The first color data signal RD1 may have a voltage level corresponding to the input image signal RGB (refer to FIG.1) input to the display device DD (refer to FIG. 1). First to third driving voltage lines VL1, VL2, and VL3 may transfer the first driving voltage ELVDD, the second driving voltage ELVSS, and the first initialization voltage Vint.

The first voltage line L1 may transfer a (2-1)-th initialization voltage Vaint1.

The second voltage line L2 may transfer a (2-2)-th initialization voltage Vaint2. The (2-2)-th initialization voltage Vaint2 may be different from the (2-1)-th initialization voltage Vaint1.

The third voltage line L3 may transfer a (2-3)-th initialization voltage Vaint3 and may be different from the (2-1)-th initialization voltage Vaint1 and the (2-2)-th initialization voltage Vaint2.

The first transistor T1 includes a first electrode S1 connected to the first driving voltage line VL1 through the fifth transistor T5, a second electrode D1, and a gate electrode G1 connected to a first end of the capacitor Cst. The first transistor T1 may be referred to as a "driving transistor T1".

The second transistor T2 includes a first electrode connected to the data line DL1/DL2/DL3, a second electrode connected to the first electrode S1 of the first transistor T1, and a gate electrode connected to the scan line GWL1. The second transistor T2 may be turned on in response to the scan signal GW1 transferred through the scan line GWL1 and may transfer the color data signal RD1/GD2/BD3 transferred through the data line DL1/DL2/DL3 to the first electrode S1 of the first transistor T1. The color data signal RD1/GD2/BD3 transferred from the data line DL1/DL2/DL3 may correspond to the first/second/third color.

The third transistor T3 includes a first electrode connected to the gate electrode G1 of the first transistor T1, a second electrode connected to the second electrode D1 of the first transistor T1, and a gate electrode connected to the scan line GCL1. The third transistor T3 may be turned on in response to the scan signal GC1 transferred through the scan line GCL1, and thus, the gate electrode G1 and the second electrode D1 of the first transistor T1 may be connected to each other, that is, the first transistor T1 may be diode-connected.

The fourth transistor T4 includes a first electrode connected to the gate electrode G1 of the first transistor T1, a second electrode connected to the third driving voltage line VL3 through which the first initialization voltage Vint is transferred, and a gate electrode connected with the scan line GIL1. The fourth transistor T4 may be referred to as a "second initialization transistor T4".

In each of the first sub-pixel PXR, the second sub-pixel PXG, and the third sub-pixel PXB, the second electrode of the fourth transistor T4 may be connected to the same driving voltage line, that is, the third driving voltage line VL3.

The fourth transistor T4 may be turned on in response to the scan signal GI1 transferred through the scan line GIL1 such that the first initialization voltage Vint is supplied to the gate electrode G1 of the first transistor T1. Accordingly, the voltage of the gate electrode G1 of the first transistor T1 may be initialized. This operation may be referred to as an "initialization operation".

The fifth transistor T5 includes a first electrode connected to the first driving voltage line VL1, a second electrode connected to the first electrode S1 of the first transistor T1, and a gate electrode connected to the emission control line EML1.

The sixth transistor T6 includes a first electrode S6 connected to the second electrode D1 of the first transistor T1, a second electrode D6 connected to an anode of the light emitting element RE11/GE15/BE12, and a gate electrode G6 connected to the emission control line EML1. The second electrode D6 of the sixth transistor T6 may be connected to the anode of the light emitting element RE11/GE15/BE12.

The fifth transistor T5 and the sixth transistor T6 may be simultaneously turned on in response to the emission control signal EM1 transferred through the emission control line EML1. As the fifth transistor T5 and the sixth transistor T6 are turned on, a current path may be formed from the first driving voltage line VL1 to the light emitting element RE11/GE15/BE12 through the fifth transistor T5, the first transistor T1, and the sixth transistor T6. In this case, the current flowing through the first transistor T1 may correspond to charges charged in the capacitor Cst. Accordingly, a current corresponding to the data signal RD1/GD2/BD3 may be transferred to the light emitting element RE11/GE15/BE12.

The seventh transistor T7 includes a first electrode connected to the second electrode D6 of the sixth transistor T6, a second electrode connected to a corresponding one of the first to third voltage lines L1, L2, and L3, and a gate electrode connected to the scan line GBL1. The seventh transistor T7 may be referred to as a "first initialization transistor T7".

That is, the second electrode of the seventh transistor T7 of the first sub-pixel PXR may be connected to the first voltage line L1, the second electrode of the seventh transistor T7 of the second sub-pixel PXG may be connected to the second voltage line L2, and the second electrode of the seventh transistor T7 of the third sub-pixel PXB may be connected to the third voltage line L3.

The seventh transistor T7 may be turned on in response to the scan signal GB1 transferred through the scan line GBL1 and may initialize the anode of the light emitting element RE11/GE15/BE12 with the second initialization voltage Vaint1 /Vaint2/Vaint3.

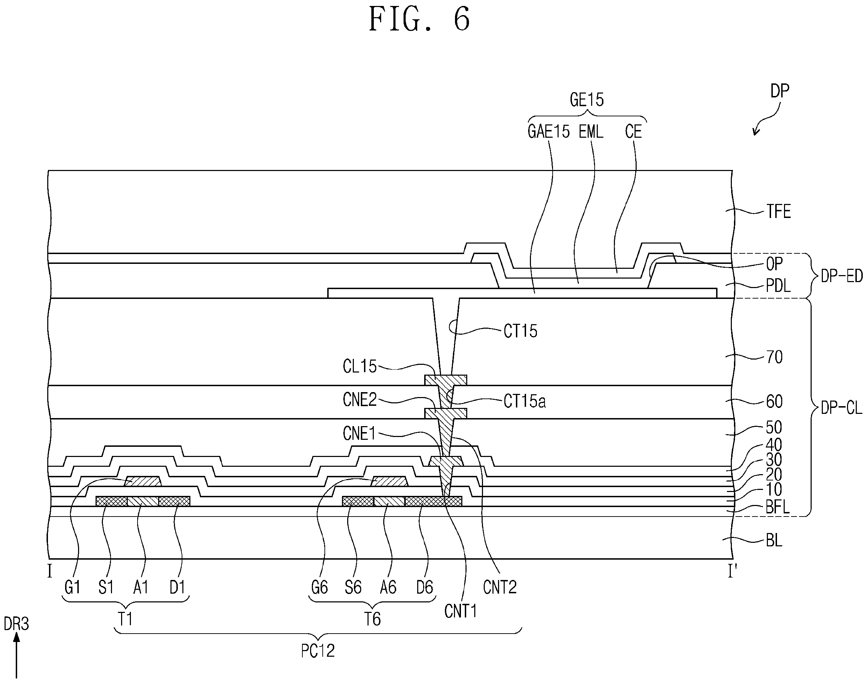

According to embodiments, the anode of the first light emitting element RE11 emitting the red light may be initialized with the (2-1)-th initialization voltage Vaint1 by the seventh transistor T7; the anode of the second light emitting element GE15 emitting the green light may be initialized with the (2-2)-th initialization voltage Vaint2 by the seventh transistor T7; the anode of the third light emitting element BE12 emitting the blue light may be initialized with the (2-3)-th initialization voltage Vaint3 by the seventh transistor T7. That is, the initialization voltages Vaint1, Vaint2, and Vaint3 may be differently provided for respective emission colors in consideration of 1) an aperture ratio of a light emitting element according to an emission color and 2) a capacitance formed between the anode and the cathode by the material of the light emitting layer EML (refer to FIG.6). Times taken to charge the anodes with the initialization voltages Vaint1, Vaint2, and Vaint3 may be compensated for, and a color deviation phenomenon which is caused when the times are different from each other, that is, the phenomenon that a color appears to be distorted may be prevented, reduced, or removed. Accordingly, the display device DD (refer to FIG. 1) whose display quality may be relatively improved may be provided.

Also, according to embodiments, each of the plurality of pixels PX may be provided not with the same initialization voltage through one wire (or voltage line) but with the initialization voltages Vaint1, Vaint2, and Vaint3 through the first to third voltage lines L1, L2, and L3. The load which is applied to the anode of each of the light emitting elements RE11, GE15, and BE12 in the initialization operation may decrease. Accordingly, the color deviation between the light emitting elements RE11, GE15, and BE12 caused by the load may be relatively improved. This may mean that display device DD (refer to FIG. 1) whose display quality may be relatively improved is provided.

The eighth transistor T8 may include a first electrode connected to the first electrode S1 of the first transistor T1, a second electrode connected to a bias voltage line VBL through which a bias voltage Vbias is transferred, and a gate electrode connected to the scan line GBL1.

The eighth transistor T8 may be turned on in response to the scan signal GB1 transferred through the scan line GBL1 and may transfer the bias voltage Vbias to the first electrode S1 of the first transistor T1 such that the voltage of the first electrode S1 of the first transistor T1 is initialized.

The first end of the capacitor Cst is connected to the gate electrode G1 of the first transistor T1 as described above, and a second end of the capacitor Cst is connected to the first driving voltage line VL1. A cathode of the light emitting element RE11/GE15/BE12 may be connected to the second driving voltage line VL2 through which the second driving voltage ELVSS is transferred.

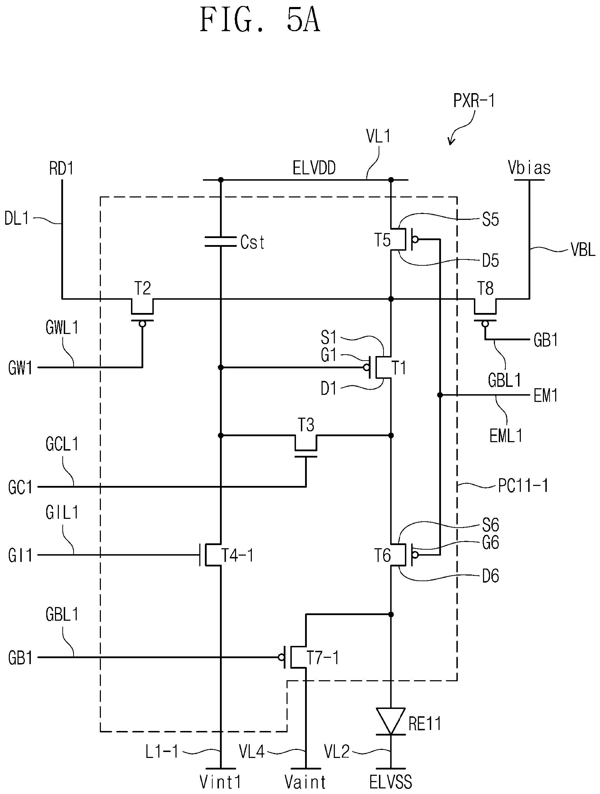

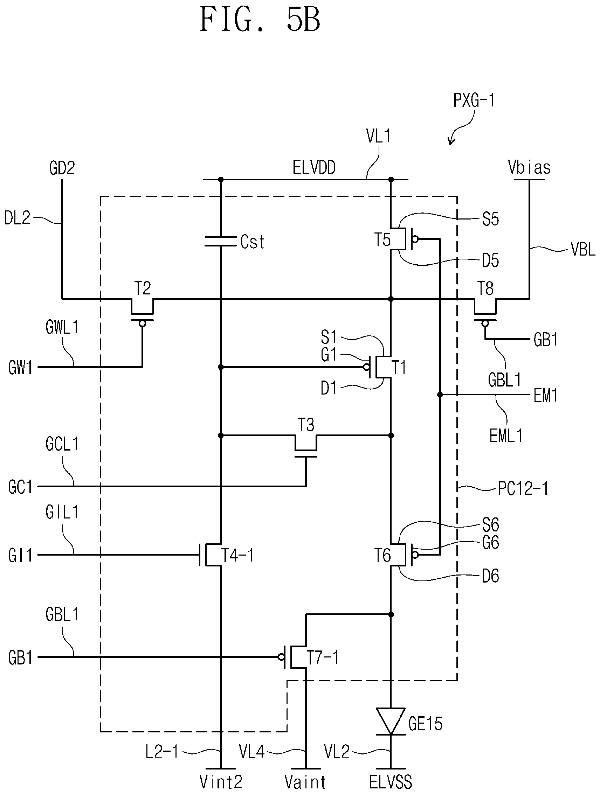

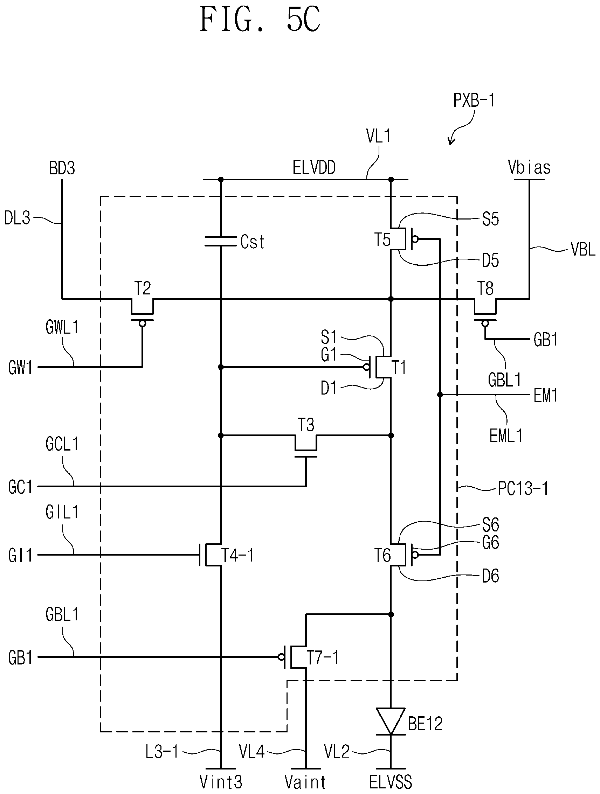

FIGS. 5A to 5C are circuit diagrams of first to third sub-pixels according to some embodiments of the present disclosure. In describing FIGS. 5A to 5C, the components which are described with reference to FIGS. 4A to 4C are marked by the same reference numerals/signs, and thus, additional description will be omitted to avoid redundancy.

Referring to FIGS. 5A to 5C, a first sub-pixel PXR-1 may include a first pixel circuit PC11-1 and the first light emitting element RE11.

A second sub-pixel PXG-1 may include a second pixel circuit PC12-1 and the second light emitting element GE15.

A third sub-pixel PXB-1 may include a third pixel circuit PC13-1 and the third light emitting element BE12.

Each of the first pixel circuit PC11-1, the second pixel circuit PC12-1, and the third pixel circuit PC13-1 may include first to eighth transistors T1, T2, T3, T4-1, T5, T6, T7-1, and T8 and the capacitor Cst.

A first voltage line L1_1 may transfer a (1-1)-th initialization voltage Vint1.

A second voltage line L2_1 may transfer a (1-2)-th initialization voltage Vint2. The (1-2)-th initialization voltage Vint2 may be different from the (1-1)-th initialization voltage Vint1.

A third voltage line L3_1 may transfer a (1-3)-th initialization voltage Vint3. The (1-3)-th initialization voltage Vint3 may be different from the (1-1)-th initialization voltage Vint1 and the (1-2)-th initialization voltage Vint2.

The fourth transistor T4-1 includes a first electrode connected to the gate electrode G1 of the first transistor T1, a second electrode connected to a corresponding one of the first to third voltage line L1_1, L2_1, and L3_1, and a gate electrode connected to the scan line GIL1. The fourth transistor T4-1 may be referred to as a "second initialization transistor T4-1".

That is, the second electrode of the fourth transistor T4-1 of the first sub-pixel PXR-1 may be connected to the first voltage line L1_1, the second electrode of the fourth transistor T4-1 of the second sub-pixel PXG-1 may be connected to the second voltage line L2_1, and the second electrode of the fourth transistor T4-1 of the third sub-pixel PXB-1 may be connected to the third voltage line L3_1.

The fourth transistor T4-1 may be turned on in response to the scan signal GI1 transferred through the scan line GIL1 and may transfer the first initialization voltage Vint1/Vint2/Vint3 to the gate electrode G1 of the first transistor T1 such that the voltage of the gate electrode G1 of the first transistor T1 is initialized. This operation may be referred to as an "initialization operation".

The gate electrode G1 of the first transistor T1 of the first sub-pixel PXR-1 may be initialized with the (1-1)-th initialization voltage Vint1 by the fourth transistor T4-1; the gate electrode G1 of the first transistor T1 of the second sub-pixel PXG-1 may be initialized with the (1-2)-th initialization voltage Vint2 by the fourth transistor T4-1; the gate electrode G1 of the first transistor T1 of the third sub-pixel PXB-1 may be initialized with the (1-3)-th initialization voltage Vint3 by the fourth transistor T4-1.

According to embodiments, each of the plurality of pixels PX may be provided not with the same initialization voltage through one wire (or voltage line) but with the initialization voltages Vint1, Vint2, and Vint3 through the first to third voltage lines L1_1, L2_1, and L3_1. The load which is applied to the gate electrode G1 of the first transistor T1 in the initialization operation may decrease. Accordingly, the gate electrode G1 of the first transistor T1 may be easily initialized, and the display device DD (refer to FIG.1) whose display quality may be relatively improved may be provided.

The seventh transistor T7-1 includes a first electrode connected to the second electrode D6 of the sixth transistor T6, a second electrode connected to a fourth driving voltage line VL4 through which the second initialization voltage Vaint is provided, and a gate electrode connected to the scan line GBL1. The seventh transistor T7-1 may be referred to as a "first initialization transistor T7-1".

In each of the first sub-pixel PXR-1, the second sub-pixel PXG-1, and the third sub-pixel PXB-1, the second electrode of the seventh transistor T7-1 may be connected to the same voltage line, that is, the fourth driving voltage line VL4.

FIG. 6 is a cross-sectional view of a display panel taken along line I-I' of FIG. 3, according to some embodiments of the present disclosure. FIG. 6 shows the cross section of a portion of the second light emitting element GE15 and the second pixel circuit PC12 as an example.

Referring to FIGS. 3 and 6, the display panel DP may include preferably all of a base layer BL, a circuit element layer DP-CL, a display element layer DP-ED, and a thin film encapsulation layer TFE. The display panel DP may further include functional layers such as a refractive index control layer. The circuit element layer DP-CL at least includes a plurality of insulating layers and a circuit element. Below, the insulating layers may include an organic layer and/or an inorganic layer.

An insulating layer, a semiconductor layer, and a conductive layer are formed through processes such as a coating process and a deposition process. Afterwards, the insulating layer, the semiconductor layer, and the conductive layer may be selectively patterned through photolithography and etching processes. A semiconductor pattern, a conductive pattern, and a signal line are formed through the above processes. Patterns located on the same layer are formed through the same process.

The base layer BL may include a synthetic resin layer. The synthetic resin layer may include a thermosetting resin material. In particular, the synthetic resin layer may be a polyimide-based resin layer, and the material thereof is not particularly limited. The synthetic resin layer may include at least one of acrylate-based resin, methacrylate-based resin, polyisoprene-based resin, vinyl-based resin, epoxy-based resin, urethane-based resin, cellulose-based resin, siloxane-based resin, polyamide-based resin, or perylene-based resin. In addition, the base layer BL may include a glass substrate, a metal substrate, an organic/inorganic composite substrate, etc.

At least one inorganic layer is formed on an upper surface of the base layer BL. The inorganic layer may include at least one of an aluminum oxide, a titanium oxide, a silicon oxide, a silicon oxynitride, a zirconium oxide, or a hafnium oxide. The inorganic layer may be formed of multiple layers. At least one of the multiple inorganic layers may constitute one buffer layer BFL.

The buffer layer BFL improves a bonding force between the base layer BL and a semiconductor pattern and/or a conductive pattern. The buffer layer BFL may include a silicon oxide layer and a silicon nitride layer. The silicon oxide layer and the silicon nitride layer may be alternately stacked.

The semiconductor pattern is located on the buffer layer BFL. The semiconductor pattern may be directly located on the buffer layer BFL. The semiconductor pattern may include a silicon semiconductor. The semiconductor pattern may include low-temperature polycrystalline silicon (LTPS). However, embodiments according to the present invention are not limited thereto. For example, the semiconductor pattern may include amorphous silicon.

An electrical property of the semiconductor pattern varies depending on whether it is doped or not. The semiconductor pattern may include a doped area and an undoped area. The doped area may be doped with an N-type dopant or a P-type dopant. A P-type transistor includes a doped area doped with the P-type dopant.

The doped area has higher conductivity than the undoped area and acts as substantially an electrode or a signal line. The undoped area corresponds substantially to an active (or channel) of a transistor. In other words, a portion of the semiconductor pattern may be the active of the transistor, another portion thereof may be a first electrode (e.g., a source electrode) or a second electrode (e.g., a drain electrode) of the transistor, and the other portion thereof may be a connection electrode or a connection signal line (or a connection electrode).

As illustrated in FIG. 6, the first electrode S1, an active A1, and the second electrode D1 of the first transistor T1 in the second pixel circuit PC12 are formed from the semiconductor pattern. The first electrode S1 and the second electrode D1 of the first transistor T1 extend from the active A1 in opposite directions. Also, the first electrode S6, an active A6, and the second electrode D6 of the sixth transistor T6 are formed from the semiconductor pattern. The first electrode S6 and the second electrode D6 of the sixth transistor T6 extend from the active A6 in opposite directions. Although not separately illustrated, the first electrode S6 of the sixth transistor T6 may be connected to the second electrode D1 of the first transistor T1.

As illustrated in FIGS. 4A to 4C, the first electrode S6 of the sixth transistor T6 may be electrically connected to the second electrode D1 of the first transistor T1.

A first insulating layer 10 is located on the buffer layer BFL. The first insulating layer 10 may overlap the pixel circuits PC11 to PC28 in common and may cover the semiconductor pattern. The first insulating layer 10 may be an inorganic layer and/or an organic layer and may have a single-layer or multi-layer structure. The first insulating layer 10 may include at least one of an aluminum oxide, a titanium oxide, a silicon oxide, a silicon oxynitride, a zirconium oxide, or a hafnium oxide. According to some embodiments, the first insulating layer 10 may be a single silicon oxide layer. As well as the first insulating layer 10, an insulating layer of the circuit element layer DP-CL to be described later may be an inorganic layer and/or an organic layer and may have a single-layer or multi-layer structure. The inorganic layer may include at least one of the materials described above.

The gate electrode G1 of the first transistor T1 is located on the first insulating layer 10. The gate electrode G1 may be a part of a metal pattern. The gate electrode G1 of the first transistor T1 overlaps the active A1 of the first transistor T1. The gate electrode G1 of the first transistor T1 may be used as a mask in the process of doping the semiconductor pattern.

A second insulating layer 20 covering the gate electrode G1 is located on the first insulating layer 10. The second insulating layer 20 may overlap the pixel circuits PC11 to PC28 in common. The second insulating layer 20 may be an inorganic layer and/or an organic layer and may have a single-layer or multi-layer structure. According to some embodiments, the second insulating layer 20 may be a single silicon oxide layer.

A third insulating layer 30 is located on the second insulating layer 20. According to some embodiments, the third insulating layer 30 may be a single silicon oxide layer.

A first connection electrode CNE1 may be located on the third insulating layer 30. The first connection electrode CNE1 may be connected to the second electrode D6 of the sixth transistor T6 through a contact hole CNT1 penetrating the first to third insulating layers 10 to 30.

A fourth insulating layer 40 which covers the first connection electrode CNE1 may be located on the third insulating layer 30. The fourth insulating layer 40 may be a single silicon oxide layer. A fifth insulating layer 50 is located on the fourth insulating layer 40. The fifth insulating layer 50 may be an organic layer. A second connection electrode CNE2 may be located on the fifth insulating layer 50. The second connection electrode CNE2 may be connected to the first connection electrode CNE1 through a contact hole CNT2 penetrating the fourth insulating layer 40 and the fifth insulating layer 50.

According to some embodiments, the data lines DL1 to DL8 may be located on the fifth insulating layer 50 on which the second connection electrode CNE2 is located.

A sixth insulating layer 60 covering the second connection electrode CNE2 is located on the fifth insulating layer 50. The sixth insulating layer 60 may be an organic layer.

A connection line CL15 may be connected to the second connection electrode CNE2 through a contact hole CT15a penetrating the sixth insulating layer 60. A seventh insulating layer 70 is located on the sixth insulating layer 60. An anode GAE15 is located on the seventh insulating layer 70. The anode GAE15 is connected to the connection line CL15 through a contact hole CT15 penetrating the seventh insulating layer 70.

An opening OP is defined in a pixel defining layer PDL. The opening OP of the pixel defining layer PDL exposes at least a portion of the anode GAE15.

The light emitting layer EML is located on the anode GAE15. The light emitting layer EML may be only located in an area corresponding to the opening OP. The light emitting layer EML may be independently formed for each of the pixel circuits PC11 to PC28.

Embodiments in which the light emitting layer EML is patterned is illustrated, but the light emitting layer EML may be located in the pixel circuits PC11 to PC28 in common. In this case, the light emitting layer EML may generate a white light or a blue light. Also, the light emitting layer EML may have a multi-layer structure. A cathode CE is located on the light emitting layer EML. The cathode CE is located in the pixel circuits PC11 to PC28 in common.

According to some embodiments, a hole control layer may be located between the anode GAE15 and the light emitting layer EML. Also, an electron control layer may be located between the light emitting layer EML and the cathode CE.

The thin film encapsulation layer TFE is located on the cathode CE. The thin film encapsulation layer TFE is located in the pixel circuits PC11 to PC28 in common. According to some embodiments, the thin film encapsulation layer TFE directly covers the cathode CE. According to some embodiments of the present disclosure, a capping layer which directly covers the cathode CE may be further formed.

The thin film encapsulation layer TFE includes at least one inorganic layer or at least one organic layer. According to some embodiments of the present disclosure, the thin film encapsulation layer TFE may include two inorganic layers and an organic layer located therebetween. According to some embodiments of the present disclosure, the thin film encapsulation layer TFE may include a plurality of inorganic layers and a plurality of organic layers, which are alternately stacked.

The encapsulation inorganic layer protects the second light emitting element GE15 from moisture or oxygen, and the encapsulation organic layer protects the second light emitting element GE15 from foreign objects such as dust particles. The encapsulation inorganic layer may include a silicon nitride layer, a silicon oxynitride layer, a silicon oxide layer, a titanium oxide layer, an aluminum oxide layer, etc., but embodiments according to the present invention are not limited thereto. The encapsulation organic layer may include an acryl-based organic layer, and embodiments according to the present invention are not limited thereto.

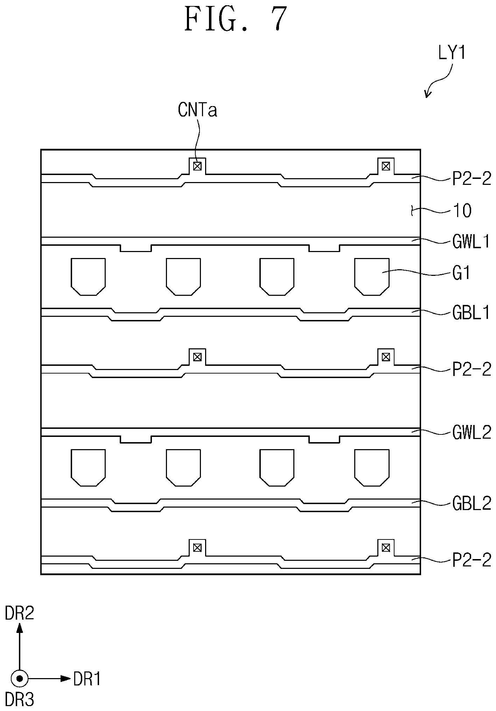

FIG. 7 is a plan view illustrating one layer of a display panel according to some embodiments of the present disclosure.

Referring to FIGS. 2, 6, and 7, a first layer LY1 may be a layer which is located on the first insulating layer 10 and is covered by the second insulating layer 20.

The gate electrode G1 of the first transistor T1, the second portion P2-2 of the second voltage line L2, the plurality of scan lines GWL1 and GWL2, and the plurality of scan lines GBL1 and GBL2 may be located on the same layer.

The gate electrode G1 of the first transistor T1 may be located on the first insulating layer 10. The second portion P2-2 of the second voltage line L2 may be located on the first insulating layer 10. The second portion P2-2 may extend in the first direction DR1.

The second portion P2-2 may be electrically connected to the first portion P1-1 of the second voltage line L2 through a contact hole CNTa.

The second portion P2-2 may be provided in plurality. The plurality of second portions P2-2 may be arranged in the second direction DR2.

The plurality of scan lines GWL1 and GWL2 may be located on the first insulating layer 10. Each of the plurality of scan lines GWL1 and GWL2 may extend in the first direction DR1. The plurality of scan lines GWL1 to GWL2 may be arranged in the second direction DR2.

The plurality of scan lines GBL1 and GBL2 may be located on the first insulating layer 10. Each of the plurality of scan lines GBL1 and GBL2 may extend in the first direction DR1. The plurality of scan lines GBL1 and GBL2 may be arranged in the second direction DR2.

In a plan view, the gate electrode G1 may be located between the scan lines GWL1 and GWL2.

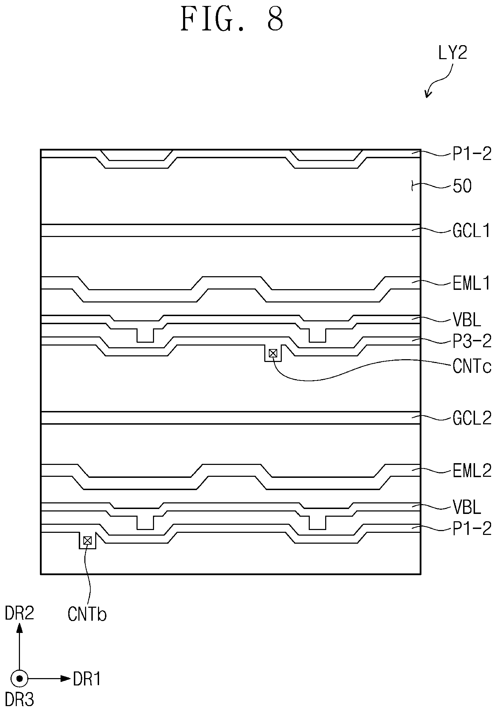

FIG. 8 is a plan view illustrating one layer of a display panel according to some embodiments of the present disclosure.

Referring to FIGS. 2, 6, and 8, a second layer LY2 may be a layer which is located on the fifth insulating layer 50 and is covered by the sixth insulating layer 60.

The second portion P1-2 of the first voltage line L1, the plurality of scan lines GCL1 and GCL2, the plurality of emission control lines EML1 and EML2, the bias voltage line VBL, the second portion P1-2, and the second portion P3-2 of the third voltage line L3 may be located on the same layer.

The second portion P1-2 of the first voltage line L1 may be located on the fifth insulating layer 50. The second portion P1-2 may extend in the first direction DR1.

The second portion P1-2 may be electrically connected to the first portion P1-1 of the first voltage line L1 through a contact hole CNTb.

The second portion P1-2 may be provided in plurality. The plurality of second portions P1-2 may be arranged in the second direction DR2.

The plurality of scan lines GCL1 and GCL2 may be located on the fifth insulating layer 50. Each of the plurality of scan lines GCL1 and GCL2 may extend in the first direction DR1. The plurality of scan lines GCL1 and GCL2 may be arranged in the second direction DR2.

The plurality of emission control lines EML1 and EML2 may be located on the fifth insulating layer 50. Each of the plurality of emission control lines EML1 and EML2 may extend in the first direction DR1. The plurality of emission control lines EML1 and EML2 may be arranged in the second direction DR2.

The bias voltage line VBL may be located on the fifth insulating layer 50. The bias voltage line VBL may extend in the first direction DR1.

The second portion P3-2 of the third voltage line L3 may be located on the fifth insulating layer 50. The second portion P3-2 may extend in the first direction DR1.

The second portion P3-2 may be electrically connected to the first portion P3-1 of the third voltage line L3 through a contact hole CNTc.

The second portion P3-2 may be provided in plurality. The plurality of second portions P3-2 may be arranged in the second direction DR2.

That is, a layer on which the second portion P1-2 of the first voltage line L1 is located may be different from a layer on which the second portion P2-2 of the second voltage line L2 are located.

That is, the second portion P1-2 of the first voltage line L1and the second portion P3-2 of the third voltage line L3 may be located in the same layer.

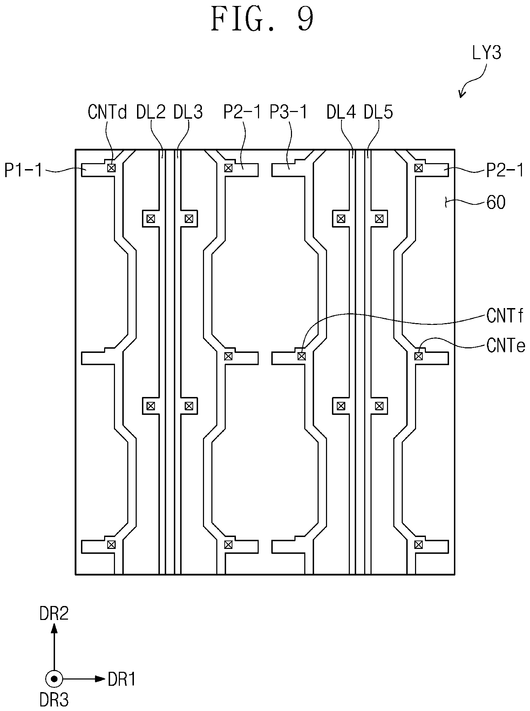

FIG. 9 is a plan view illustrating one layer of a display panel according to some embodiments of the present disclosure.

Referring to FIGS. 2, 6, and 9, a third layer LY3 may be a layer which is located on the sixth insulating layer 60 and is covered by the seventh insulating layer 70.

The first portion P1-1 of the first voltage line L1, the second data line DL2, the third data line DL3, the first portion P2-1 of the second voltage line L2, the first portion P3-1 of the third voltage line L3, the fourth data line DL4, and the fifth data line DL5 may be located on the same layer.

The first portion P1-1 of the first voltage line L1 may be located on the sixth insulating layer 60. The first portion P1-1 may extend in the second direction DR2 intersecting the first direction DR1.

The first portion P1-1 may be provided in plurality. The plurality of first portions P1-1 may be arranged in the first direction DR1.

In a plan view, a contact hole CNTd of the third layer LY3 may overlap the contact hole CNTb (refer to FIG. 8) of the second layer LY2 (refer to FIG. 8).

The first portion P1-1 may be electrically connected to the second portion P1-2 through the contact hole CNTd.

The second data line DL2 may be located on the sixth insulating layer 60. The second data line DL2 may extend in the second direction DR2. The second data line DL2 may be spaced from the first portion P1-1 in the first direction DR1.

The third data line DL3 may be located on the sixth insulating layer 60. The third data line DL3 may extend in the second direction DR2. The third data line DL3 may be spaced from the second data line DL2 in the first direction DR1.

The first portion P2-1 of the second voltage line L2 may be located on the sixth insulating layer 60. The first portion P2-1 may extend in the second direction DR2.

The first portion P2-1 may be provided in plurality. The plurality of first portions P2-1 may be arranged in the first direction DR1.

In a plan view, a contact hole CNTe of the third layer LY3 may overlap the contact hole CNTa of the first layer LY1 (refer to FIG. 7).

The first portion P2-1 may be electrically connected to the second portion P2-2 through the contact hole CNTe.

The first portion P3-1 of the third voltage line L3 may be located on the sixth insulating layer 60. The first portion P3-1 may extend in the second direction DR2.

The first portion P3-1 may be provided in plurality. The plurality of first portions P3-1 may be arranged in the first direction DR1.

In a plan view, a contact hole CNTf of the third layer LY3 may overlap the contact hole CNTc (refer to FIG. 8) of the second layer LY2 (refer to FIG. 8).

The first portion P3-1 may be electrically connected to the second portion P3-2 through the contact hole CNTf.

The fourth data line DL4 may be located on the sixth insulating layer 60. The fourth data line DL4 may extend in the second direction DR2. The fourth data line DL4 may be spaced from the first portion P3-1 in the first direction DR1.

The fifth data line DL5 may be located on the sixth insulating layer 60. The fifth data line DL5 may extend in the second direction DR2. The fifth data line DL5 may be spaced from the fourth data line DL4 in the first direction DR1.

That is, a layer on which the first portion P1-1 of the first voltage line L1, the first portion P2-1 of the second voltage line L2, the first portion P3-1 of the third voltage line L3 are located may be different from layers on which the second portion P1-2 of the first voltage line L1, the second portion P2-2 of the second voltage line L2, and the second portion P3-2 of the third voltage line L3 are located.

However, this is provided as an example. If eg the first to third layers LY1, LY2, and LY3 according to some embodiments of the present disclosure are located on/in different layers, layers where the first to third layers LY1, LY2, and LY3 are located are not limited to the above examples.

According to the above description, first to third voltage lines may have a mesh structure. In this case, compared to a conventional voltage line extending in a second direction, the first to third voltage lines may further include second portions extending in a first direction. The area of wiring for providing initialization voltages may increase, and the resistance thereof may decrease. As the first to third voltage lines transfer the initialization voltages, the load of the first to third voltage lines may decrease. Accordingly, a display device with relatively improved reliability may be provided.

Also, according to the above description, the first to third voltage lines may be respectively connected to first to third sub-pixels. Accordingly, the phenomenon that charges flow to another sub-pixel adjacent to one sub-pixel while the one sub-pixel is driven may be prevented, reduced, or removed. A color deviation capable of being caused by a lateral leakage current may be prevented, reduced, or removed. Accordingly, a display device whose display quality may be relatively improved may be provided.

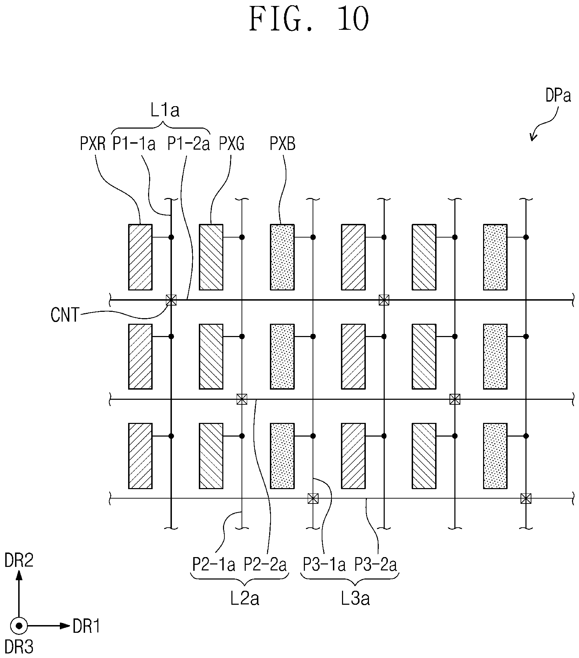

FIG. 10 illustrates a partial configuration of a display panel according to some embodiments of the present disclosure. In the description of FIG. 10, the components which are described with reference to FIG. 2 are marked by the same reference numerals/signs, and thus, additional description will be omitted to avoid redundancy.

Referring to FIG. 10, a display panel DPa may include a plurality of first sub-pixels PXR, a plurality of second sub-pixels PXG, a plurality of third sub-pixels PXB, a first voltage line L1a, a second voltage line L2a, and a third voltage line L3a.

Each of the plurality of first sub-pixels PXR may be electrically connected to the first voltage line L1a.

The initialization voltage Vint (refer to FIG.1) or the second initialization voltage Vaint (refer to FIG.1) corresponding to the plurality of first sub-pixels PXR may be provided to the first voltage line L1a.

The first voltage line L1a may include a (1-1)-th portion P1-1a and a (1-2)-th portion P1-2a. The (1-1)-th portion P1-1a may extend in the second direction DR2. The (1-1)-th portion P1-1a may be adjacent to the plurality of first sub-pixels PXR in the first direction DR1. The (1-2)-th portion P1-2a may extend in the first direction DR1. The (1-2)-th portion P1-2a may be electrically connected to the (1-1)-th portion P1-1a. The (1-2)-th portion P1-2a may extend in the first direction DR1. In a plan view, the first voltage line L1a may have a mesh shape.

The (1-1)-th portion P1-1a and the (1-2)-th portion P1-2a may be located in different layers. The (1-1)-th portion P1-1a and the (1-2)-th portion P1-2a may be electrically connected through a contact hole CNT.

Each of the plurality of second sub-pixels PXG may be electrically connected to the second voltage line L2a.

The first initialization voltage Vint (refer to FIG.1) or the second initialization voltage Vaint (refer to FIG.1) corresponding to the second sub-pixel PXG may be provided to the second voltage line L2a.

The second voltage line L2a may include a (2-1)-th portionP2-1a and a (2-2)-th portion P2-2a. The (2-1)-th portion P2-1a may extend in the second direction DR2. The (2-1)-th portion P2-1a may be adjacent to the plurality of second sub-pixels PXG in the first direction DR1. The (2-2)-th portion P2-2a may extend in the first direction DR1. The (2-2)-th portion P2-2a may be electrically connected to the (2-1)-th portion P2-1a. In a plan view, the second voltage line L2a may have a mesh shape.

The (2-1)-th portion P2-1a and the (2-2)-th portion P2-2a may be located in different layers. The (2-1)-th portion P2-1a and the (2-2)-th portion P2-2a may be electrically connected through a contact hole CNT.

Each of the plurality of third sub-pixels PXB may be electrically connected to the third voltage line L3a.

The first initialization voltage Vint (refer to FIG.1) or the second initialization voltage Vaint (refer to FIG.1) corresponding to the third sub-pixel PXB may be provided to the third voltage line L3a.

The third voltage line L3a may include a (3-1)-th portion P3-1a and a (3-2)-th portion P3-2a. The (3-1)-th portion P3-1a may extend in the second direction DR2. The (3-1)-th portion P3-1a may be adjacent to the plurality of third sub-pixels PXB in the first direction DR1. The (3-2)-th portion P3-2a may extend in the first direction DR1. The (3-2)-th portion P3-2a may be electrically connected to the (3-1)-th portion P3-1a. In a plan view, the third voltage line L3a may have a mesh shape.

The (3-1)-th portion P3-1a and the (3-2)-th portion P3-2a may be located in different layers. The (3-1)-th portion P3-1a and the (3-2)-th portion P3-2a may be electrically connected through a contact hole CNT.

According to embodiments, the first to third voltage lines L1a, L2a, and L3a may have a mesh structure. In this case, compared to a conventional voltage line extending in the second direction DR2, the first to third voltage lines L1a, L2a, and L3a may further include the second portions P1-2a, P2-2a, and P3-2a extending in the first direction DR1. The area of the wiring for providing the initialization voltages Vint and Vaint (refer to FIG.1) may increase, and the resistance thereof may decrease. As the first to third voltage lines L1a, L2a, and L3a transfer the initialization voltages Vint and Vaint (refer to FIG. 1), the load of the first to third voltage lines L1a, L2a, and L3a may decrease. In this case, the IR (product of current and resistance) drop phenomenon may be reduced or removed. Accordingly, the display device DD (refer to FIG. 1) in which reliability may be relatively improved and/or power consumption is reduced may be provided.

Also, unlike some embodiments, when the initialization voltage Vint or Vaint (refer to FIG.1) is provided through a common wire, the common wire may function as a charge transfer path in the process of driving the first to third sub-pixels PXR, PXG, and PXB. While one sub-pixel is driven, charges may flow to another sub-pixel adjacent thereto through the common wire, that is, a lateral leakage current may be caused. However, according to embodiments, the first to third voltage lines L1a, L2a, and L3a may be respectively connected to the first to third sub-pixels PXR, PXG, and PXB. Accordingly, the phenomenon that charges flow to another sub-pixel adjacent to one sub-pixel while the one sub-pixel is driven may be prevented, reduced, or removed. A color deviation or color dragging phenomenon capable of being caused by the lateral leakage current may be prevented, reduced, or removed. Accordingly, the display device DD (refer to FIG. 1) with relatively improved display quality may be provided.

According to some embodiments of the present disclosure, in a plan view, the second portions P1-2a, P2-2a, and P3-2a may be spaced apart from each other in the second direction DR2. One second portion P1-2a, P2-2a, or P3-2a may be located between two pixels adjacent in the second direction DR2 from among the plurality of pixels PX (refer to FIG. 1). The plurality of pixels PX (refer to FIG. 1) may implement a high PPI (Pixels Per Inch). Accordingly, the display device DD (refer to FIG. 1) with relatively improved display quality may be provided.

Arrangements are set out in the following clauses:
Clause 1. A display device comprising:
   a data line extending in a first direction;
   a voltage line configured to transfer an initialization voltage; and
   a pixel electrically connected to the data line and the voltage line,
   wherein the pixel includes a pixel circuit and a light emitting element,
   wherein the voltage line includes a first portion extending in the first direction and a second portion electrically connected to the first portion and extending in a second direction intersecting the first direction,
   wherein the first portion and the second portion are in different layers, and
   wherein the data line and the first portion are in a same layer.
Clause 2. The display device of clause 1, wherein the pixel circuit includes a first initialization transistor connected between the voltage line and the light emitting element.
Clause 3. The display device of clause 1 or 2, wherein the pixel circuit includes:
   a driving transistor; and
   a second initialization transistor connected between a gate electrode of the driving transistor and the voltage line.
Clause 4. The display device of any preceding clause, wherein the pixel circuit is provided in plurality, and
   wherein the plurality of pixel circuits are arranged along the first direction.
Clause 5. The display device of any preceding clause, wherein the light emitting element is provided in plurality, and
   wherein the plurality of light emitting elements are electrically connected to the plurality of pixel circuits, respectively.
Clause 6. The display device of clause 5, wherein, in a plan view, some of the plurality of light emitting elements overlap the corresponding pixel circuits.
Clause 7. The display device of clause 6, wherein, in the plan view, the others of the plurality of light emitting elements do not overlap the corresponding pixel circuits.

While the present invention has been described with reference to embodiments thereof, it will be apparent to those of ordinary skill in the art that various changes and modifications may be made thereto without departing from the scope of the present invention as set forth in the following claims.

## Claims

1. A display device comprising:
a first data line and a second data line each extending in a first direction;
a first voltage line and a second voltage line configured to provide different initialization voltages; and
a plurality of pixels,
wherein the plurality of pixels include:
a first sub-pixel electrically connected to the first data line and the first voltage line and including a first pixel circuit and a first light emitting element; and
a second sub-pixel adjacent to the first sub-pixel, electrically connected to the second data line and the second voltage line, and including a second pixel circuit and a second light emitting element,
wherein the first voltage line includes a [1-1]-th portion extending in the first direction and a [1-2]-th portion electrically connected to the [1-1]-th portion and extending in a second direction intersecting the first direction, and
wherein the second voltage line includes a [2-1]-th portion extending in the first direction and a [2-2]-th portion electrically connected to the [2-1]-th portion and extending in the second direction.

2. The display device of claim 1, wherein the [1-1]-th portion and the [2-1]-th portion are in a same layer, and
wherein the [1-1]-th portion and the [1-2]-th portion are in different layers.

3. The display device of claim 1 or 2, wherein the first and second data lines, the [1-1]-th portion, and the [2-1]-th portion are in a same layer.

4. The display device of any preceding claim, wherein the first pixel circuit includes a [1-1]-th initialization transistor connected between the first voltage line and the first light emitting element, and wherein the second pixel circuit includes a [1-2]-th initialization transistor connected between the second voltage line and the second light emitting element.

5. The display device of any preceding claim, wherein the first pixel circuit includes a first driving transistor and a [2-1]-th initialization transistor connected between a gate electrode of the first driving transistor and the first voltage line, and
wherein the second pixel circuit includes a second driving transistor and a [2-2]-th initialization transistor connected between a gate electrode of the second driving transistor and the second voltage line.

6. The display device of any preceding claim, further comprising:
a third data line; and
a third voltage line configured to provide a voltage different from those of the first voltage line and the second voltage line,
wherein the plurality of pixels further include a third pixel adjacent to the second sub-pixel and including a third pixel circuit and a third light emitting element, and
wherein the third pixel is electrically connected to the third voltage line.

7. The display device of claim 6, wherein the third voltage line includes a [3-1]-th portion extending in the first direction and a [3-2]-th portion electrically connected to the [3-1]-th portion and extending in the second direction.

8. The display device of claim 6 or 7, wherein different color data are provided to the first to third data lines.

9. The display device of any one of claims 6 to 8, wherein, in a plan view, each of the first voltage line, the second voltage line, and the third voltage line has a mesh structure.

10. The display device of any preceding claim, wherein each of the first pixel circuit and the second pixel circuit are provided in plurality,
wherein the plurality of first pixel circuits are arranged along the first direction,
wherein the plurality of second pixel circuits are arranged along the first direction, and
wherein the plurality of first pixel circuits are respectively spaced from the plurality of second pixel circuits in the second direction.

11. The display device of claim 10, wherein the first light emitting element is provided in plurality,
wherein the plurality of first light emitting elements are electrically connected to the plurality of first pixel circuits, respectively,
wherein, in a plan view, some of the plurality of first light emitting elements overlap the corresponding first pixel circuits, and
wherein, in the plan view, the others of the plurality of first light emitting elements do not overlap the corresponding first pixel circuits.

12. The display device of any preceding claim, wherein, in a plan view, the second data line overlaps the first light emitting element and does not overlap the second light emitting element.

13. The display device of any preceding claim, wherein the first data line and the second data line are spaced from each other in the second direction.
